# FASCICULE DE BREVET EUROPEEN

(11) **EP 3 907 567 B1**
(45) Date de publication et mention de la délivrance du brevet: **08.01.2025**
(21) Numéro de dépôt: 21182494.1
(22) Date de dépôt: 19.03.2019
(51) Int. Cl.: G04B 17/06, G04B 17/22, G04D 3/00

(54) **ORGANE DE SUPPORT POUR LE TRAITEMENT THERMIQUE D'UNE PLAQUETTE**
TRÄGERELEMENT FÜR DIE WÄRMEBEHANDLUNG EINES PLÄTTCHENS
SUPPORT MEMBER FOR THERMAL TREATMENT OF A PLATE

(30) Priorité: 20.03.2018 EP 18162729
(43) Date de publication de la demande: 10.11.2021
(62) Demande divisionnaire de: 19717200.0
(73) Titulaire: Patek Philippe SA Genève, 1204 Genève (CH)
(72) Inventeur: Jeanneret, Sylvain, 1228 Plan-les-Ouates (CH)
(74) Mandataire: Micheli & Cie SA

(56) Documents cités:
- EP-A1- 2 799 939
- EP-A1- 2 799 940
- EP-A1- 3 088 969
- EP-A2- 2 784 600
- WO-A1-2010/057777

## Description

La présente invention se rapporte à un procédé de fabrication de composants horlogers, tels que des spiraux, des ancres, des roues, des aiguilles, des bascules, des leviers, des ressorts ou des balanciers, en silicium.

Des procédés de fabrication de composants horlogers en silicium ont été décrits notamment dans les documents EP 0732635, EP 1422436, EP 2215531, EP 3181938, EP 2784600 et EP 3088969.

La présente invention propose un organe de support qui facilite la mise en oeuvre d'un procédé de fabrication de composants horlogers en silicium et plus précisément la mise en oeuvre d'un traitement thermique d'une plaquette de silicium dans laquelle sont gravés des composants horlogers. Cet organe de support est défini dans la revendication 1 et les revendications qui en dépendent.

D'autres caractéristiques et avantages de la présente invention apparaîtront à la lecture de la description détaillée suivante faite en référence aux dessins annexés dans lesquels :
- les figures 1 à 11 montrent schématiquement des étapes successives d'un procédé de fabrication de composants horlogers en silicium ;
- les figures 12 et 13 sont respectivement une vue en perspective et une vue de profil d'un organe de support selon l'invention utilisé dans ledit procédé de fabrication de composants horlogers en silicium pour supporter une plaquette de silicium pendant un traitement d'oxydation thermique de cette dernière ;
- les figures 14 et 15 montrent schématiquement une étape dudit procédé de fabrication de composants horlogers en silicium, dans laquelle une plaquette de silicium gravée est libérée d'un substrat composite ;
- la figure 16 montre un substrat composite à partir duquel peut être mis en oeuvre un procédé selon un autre exemple de réalisation.

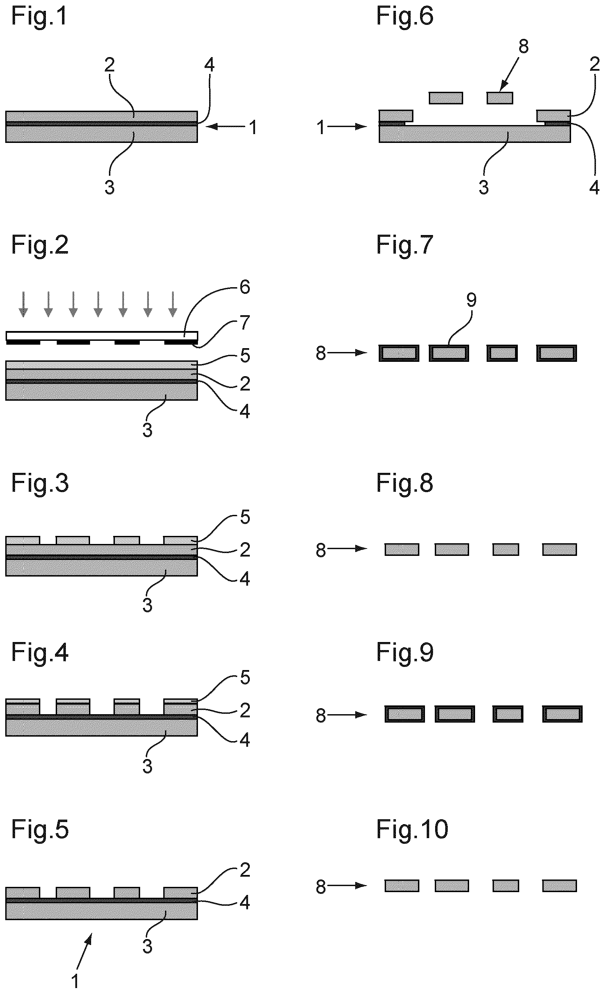

Un procédé de fabrication de composants horlogers en silicium, notamment pour montres-bracelets, comprend selon un exemple de réalisation particulier les étapes successives illustrées aux figures 1 à 11.

A une première étape (figure 1), on se munit d'un substrat 1 de type silicium sur isolant connu sous l'acronyme SOI (Silicon-On-Insulator). Le substrat 1 comprend une couche supérieure de silicium 2, une couche inférieure de silicium 3 et, entre les deux, une couche intermédiaire d'oxyde de silicium 4. Le silicium est monocristallin, polycristallin ou amorphe. Il peut être dopé ou non. L'épaisseur de la couche supérieure de silicium 2 est choisie en fonction de l'épaisseur des composants que l'on souhaite réaliser. La couche inférieure de silicium 3 sert à conférer au substrat 1 une rigidité suffisante facilitant sa manipulation et la mise en oeuvre des opérations qui vont être décrites ci-dessous.

A une deuxième étape (figure 2), on dépose sur la couche supérieure de silicium 2 une couche de laque photosensible 5 et on structure cette couche 5 par photolithographie. Plus précisément, on expose la couche de laque photosensible 5 à des rayons ultra-violets à travers un masque 6, typiquement en verre ou en quartz, portant une structure 7, typiquement en chrome, à transférer. Puis la couche de laque photosensible 5 est développée et cuite (figure 3). A l'issue de ces opérations, la couche de laque photosensible 5 présente la même forme que la structure 7 et constitue à son tour un masque, ladite forme correspondant à celle d'un lot de composants horlogers à fabriquer.

A une étape suivante (figure 4), on grave la couche supérieure de silicium 2 à travers le masque de laque photosensible 5 par gravure ionique réactive profonde dite DRIE (Deep Reactive Ion Etching) afin de former dans cette couche 2 les composants horlogers. La gravure est arrêtée par la couche intermédiaire d'oxyde de silicium 4, permettant ainsi de définir une épaisseur précise pour les composants horlogers. Les paramètres de gravure peuvent être ajustés en fonction des composants, pour obtenir des caractéristiques particulières en termes par exemple de rugosité ou d'angle des flancs. Les composants horlogers formés dans la couche supérieure de silicium 2 sont de préférence identiques mais ils pourraient en variante être répartis en plusieurs groupes, chaque groupe correspondant à un type de composant. Les composants horlogers comprennent par exemple au moins l'un des types de composants suivants : spiraux, ancres, roues, notamment roues d'échappement, aiguilles, bascules, leviers, ressorts, balanciers, ou des parties de tels composants. Ce procédé convient particulièrement à des composants d'organe réglant et plus généralement à des composants de mouvement horloger nécessitant une faible masse et/ou une faible inertie.

Le masque de laque photosensible 5 est ensuite éliminé par gravure chimique ou gravure plasma (figure 5).

A une étape suivante (figure 6), on libère du substrat 1, d'une manière qui sera décrite plus loin, une plaquette 8 formée par au moins tout ou partie de la couche supérieure de silicium 2 gravée. Cette plaquette 8 contient une structure de base et les composants horlogers attachés à la structure de base par des ponts de matière laissés lors de la gravure.

Puis la plaquette 8 est placée dans un four d'oxydation pour être soumise à un traitement thermique, typiquement entre 600°C et 1300°C, oxydant toute la surface extérieure des composants horlogers (figure 7). La couche d'oxyde de silicium (SiO₂) 9 qui recouvre alors la plaquette 8 et en particulier les composants horlogers se forme en consommant du silicium de la plaquette 8, ce qui fait reculer l'interface entre le silicium et l'oxyde de silicium et atténue les défauts de surface du silicium. En éliminant ensuite l'oxyde de silicium (figure 8), par gravure humide, gravure en phase vapeur ou gravure sèche, on obtient des composants horlogers ayant un bon état de surface. En particulier, la rugosité des flancs due à la gravure DRIE et les défauts cristallins de surface sont fortement réduits.

A ce stade du procédé, on peut mesurer des caractéristiques physiques des composants horlogers ou de certains d'entre eux, notamment leurs dimensions. Grâce à l'étape précédente d'oxydation - désoxydation, ces caractéristiques physiques sont bien définies et leur mesure peut donc être précise, n'étant pas perturbée par les défauts de surface. Dans le cas de spiraux, on peut déterminer leur raideur. Pour un spiral donné, la raideur peut être déterminée en couplant le spiral, alors qu'il est encore attaché à la plaquette 8 ou détaché de la plaquette 8, à un balancier d'inertie prédéterminée, en mesurant la fréquence de l'ensemble balancier-spiral et en déduisant de cette mesure, par calcul, la raideur du spiral. On peut plus particulièrement mettre en oeuvre le procédé décrit dans la demande de brevet EP 3181938, à savoir déterminer la raideur des spiraux, calculer une épaisseur de matériau à retirer des spiraux pour obtenir une raideur souhaitée, puis retirer cette épaisseur de matériau afin d'obtenir des spiraux de la raideur souhaitée. Pour retirer ladite épaisseur de matériau, on peut oxyder thermiquement la plaquette 8 et ses composants horlogers (figure 9) puis la désoxyder (figure 10), de la même manière que décrit précédemment en référence aux figures 7 et 8. Les opérations de détermination de la raideur, de calcul de l'épaisseur à retirer et de retrait de cette épaisseur par oxydation - désoxydation peuvent être répétées si nécessaire pour affiner la précision dimensionnelle des spiraux.

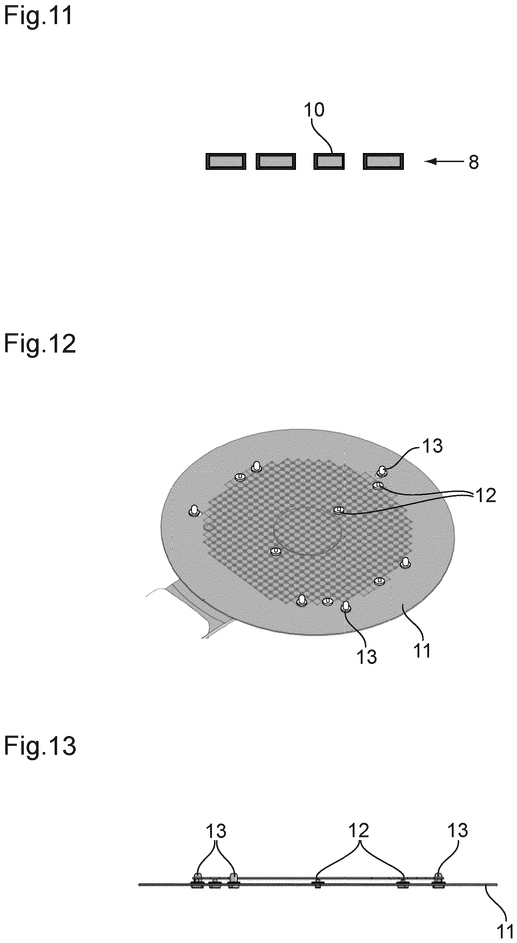

A encore une autre étape du procédé (figure 11), une couche d'oxyde de silicium (SiO₂) 10 est formée sur la plaquette 8 et ses composants horlogers, par exemple par oxydation thermique ou par dépôt chimique ou physique en phase vapeur (CVD, PVD). Cette couche d'oxyde de silicium 10 qui enrobe les composants horlogers renforce leur résistance mécanique. Dans le cas d'un spiral, la couche d'oxyde de silicium 10 a une épaisseur qui lui permet de compenser les variations en fonction de la température du module d'élasticité de l'âme en silicium ainsi que les variations en fonction de la température du moment d'inertie du balancier que le spiral est destiné à équiper, afin que la fréquence de l'oscillateur balancier-spiral soit insensible à la température, comme décrit dans les brevets EP 1422436 et EP 2215531.

A une étape finale, les composants horlogers sont détachés de la structure de base de la plaquette 8.

Selon l'invention, durant les étapes d'oxydation (figures 7 et 9 et, le cas échéant, figure 11), la plaquette 8 est supportée horizontalement par une plaque de support 11 telle qu'illustrée aux figures 12 et 13, pouvant être manipulée manuellement ou par un robot. Cette plaque de support 11 est dans un matériau compatible avec le traitement d'oxydation, par exemple le quartz, le silicium ou le carbure de silicium. Pour permettre une oxydation homogène de la plaquette 8, cette dernière est surélevée par rapport à la plaquette de support 11 par des entretoises 12 qui soutiennent la plaquette 8 dans des zones qui ne contiennent pas de composants (notamment entre les composants). La plaquette 8 est empêchée de bouger horizontalement par des éléments de retenue 13 coopérant avec le pourtour de la plaquette 8. Les entretoises 12 et les éléments de retenue 13 sont de forme générale cylindrique. Ils sont solidaires de la plaque de support 11, par exemple fixés à la plaque de support 11 par des liaisons de type baïonnette. Ils sont réalisés par exemple en quartz ou en carbure de silicium, et peuvent être dans le même matériau ou dans des matériaux différents. Dans un exemple de réalisation préféré, la plaque de support 11 est en silicium et les entretoises et éléments de retenue 12, 13 sont en quartz. Une telle plaque de support 11 avec ses entretoises 12 et éléments de retenue 13 peut aussi être utilisée pendant l'étape de la figure 11 lorsque celle-ci consiste en une opération de dépôt CVD ou PVD.

De préférence, durant le traitement d'oxydation de la figure 9, la plaquette 8 est placée sur la plaque de support 11 dans une position retournée par rapport au traitement d'oxydation de la figure 7. De même, durant le traitement d'oxydation ou de dépôt de la figure 11, la plaquette 8 est placée sur la plaque de support 11 dans une position retournée par rapport au traitement d'oxydation de la figure 9. Ceci permet d'éviter que des déformations permanentes se produisent dans les composants horlogers sous l'effet de la pesanteur et de la chaleur, ou d'au moins limiter ces déformations.

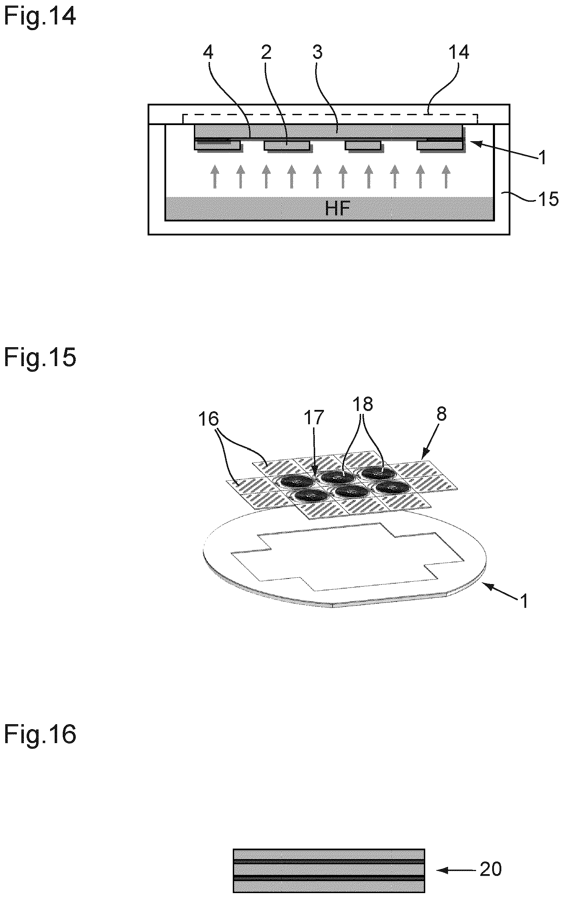

L'étape de libération de la plaquette 8 du substrat 1 (figure 6) peut être mise en oeuvre par élimination de toute la couche inférieure de silicium 3 et de toute la couche intermédiaire d'oxyde de silicium 4 par gravure chimique ou gravure plasma. On peut aussi retirer la couche inférieure de silicium 3 et la couche intermédiaire d'oxyde de silicium 4 seulement au dos des composants ou des groupes de composants, la plaquette 8 gardant alors une partie de ces couches 3, 4. Toutefois, ces opérations sont longues et coûteuses. De préférence, la plaquette 8 est formée par une partie de la couche supérieure de silicium 2 et sa libération du substrat 1 est mise en oeuvre de la manière exposée ci-dessous et illustrée aux figures 14 et 15.

On fixe le substrat 1 gravé tel que montré à la figure 5 contre un élément chauffant 14 dans une chambre fermée 15 (figure 14), la couche supérieure de silicium 2 étant orientée vers le bas, la couche inférieure de silicium 3, orientée donc vers le haut, étant contre l'élément chauffant 14. Le mode de fixation du substrat 1 contre l'élément chauffant 14 peut être électrostatique (par application d'un champ électrique) ou mécanique. Une solution d'acide fluorhydrique (HF) est ajoutée dans la chambre 15, hors de contact avec le substrat 1. Les vapeurs de l'acide fluorhydrique qui saturent alors l'intérieur de la chambre 15 gravent la couche intermédiaire d'oxyde de silicium 4, sans attaquer le silicium. L'élément chauffant 14, régulé en température, empêche la condensation de l'eau produite par la réaction entre l'acide fluorhydrique et l'oxyde de silicium, condensation qui provoquerait un collage entre la partie à libérer et le reste du substrat 1.

La partie à libérer, à savoir la plaquette 8, est définie préalablement par une saignée réalisée lors de la gravure de la couche supérieure de silicium 2 et qui forme le pourtour de la plaquette 8. Pendant cette même gravure de la couche supérieure de silicium 2, des ouvertures 16, par exemple en forme de hachures comme représenté à la figure 15, sont gravées dans la plaquette 8 autour d'une zone centrale 17 comprenant les composants. Ces ouvertures 16 permettent le passage de la vapeur d'acide fluorhydrique.

La figure 15 montre un exemple de plaquette 8 ayant une forme constituée de parties rectangulaires ou carrées. D'autres formes peuvent bien sûr être envisagées, par exemple la forme circulaire. A la figure 15 on peut voir les composants horlogers 18 portés par la plaquette 8, ici constitués de spiraux. Ces composants horlogers ont été représentés en nombre réduit par rapport à leur nombre réel, afin de faciliter la lecture du dessin.

Les composants horlogers fabriqués par le procédé décrit ci-dessus peuvent avoir des dimensions très précises et de bons états de surface qui amélioreront la précision de fonctionnement et le rendement des mécanismes qui les utiliseront.

Des modifications du procédé tel que décrit ci-dessus sont bien entendu possibles.

Par exemple, bien que les deux étapes d'oxydation - désoxydation (figures 7, 8 et figures 9, 10) pour respectivement améliorer l'état de surface des composants horlogers et ajuster leur raideur (dans le cas de spiraux) soient particulièrement avantageuses, on pourrait n'en prévoir qu'une, à la fois pour améliorer l'état de surface et ajuster la raideur, que précéderait une étape de détermination de la raideur.

On pourrait aussi partir d'un substrat double ou triple SOI, voire plus, c'est-à-dire d'un substrat comprenant plus de deux couches de silicium séparées par des couches intermédiaires d'oxyde de silicium, comme le substrat 20 montré à la figure 16, et graver les composants horlogers dans un groupe de couches supérieures qui serait ensuite libéré du substrat. Les composants horlogers auraient alors une structure composite comprenant une ou plusieurs couches intermédiaires d'oxyde de silicium.

Le masque de laque photosensible 5 qui sert à structurer la couche supérieure de silicium 2 (figure 3) pourrait être remplacé par un masque d'oxyde de silicium. On pourrait aussi associer un masque de laque photosensible et un masque d'oxyde de silicium pour réaliser par gravure dans la couche supérieure de silicium ou dans un groupe de couches supérieures des composants horlogers multiniveaux.

Dans d'autres variantes, on pourrait graver le substrat depuis ses deux faces.

La ou les couches d'oxydes de silicium servant à arrêter la gravure pourraient être renforcées par une ou des couches de type parylène.

Enfin, la présente invention n'exclut pas non plus l'utilisation d'une ou plusieurs couches métalliques pour arrêter la gravure.

## Revendications

1. Procédé de traitement thermique d'une plaquette de silicium (8) dans laquelle sont gravés des composants horlogers, procédé dans lequel la plaquette (8) est oxydée thermiquement dans un four d'oxydation, la plaquette (8) étant supportée pendant l'oxydation par un organe de support (11, 12, 13) comprenant une plaque de support (11) et des entretoises (12) et éléments de retenue (13) portés par la plaque de support (11), les entretoises (12) maintenant un écartement entre la plaque de support (11) et la plaquette (8), les éléments de retenue (13) empêchant la plaquette (8) de bouger horizontalement.

2. Procédé selon la revendication 1, dans lequel la plaque de support (11) est en silicium, quartz ou carbure de silicium.

3. Procédé selon la revendication 1 ou 2, dans lequel les entretoises (12) et les éléments de retenue (13) sont en quartz ou carbure de silicium.

4. Procédé selon l'une des revendications 1 à 3, dans lequel les entretoises (12) et les éléments de retenue (13) sont fixés à la plaque de support (11) par des liaisons de type baïonnette.

## Patentansprüche

1. Verfahren zur Wärmebehandlung eines Siliziumplättchens (8), in das Uhrenkomponenten geätzt werden, wobei in dem Verfahren das Plättchen (8) in einem Oxidationsofen thermisch oxidiert wird, wobei das Plättchen (8) während der Oxidation durch ein Trägerelement (11, 12, 13) getragen wird, das eine Trägerplatte (11) und Abstandshalter (12) und Halteelemente (13) umfasst, die von der Trägerplatte (11) getragen werden, wobei die Abstandshalter (12) einen Abstand zwischen der Trägerplatte (11) und dem Plättchen (8) bewahren, wobei die Halteelemente (13) verhindern, dass das Plättchen (8) sich horizontal bewegt.

2. Verfahren nach Anspruch 1, wobei die Trägerplatte (11) aus Silizium, Quarz oder Siliziumcarbid besteht.

3. Verfahren nach Anspruch 1 oder 2, wobei die Abstandshalter (12) und die Halteelemente (13) aus Quarz oder Siliziumcarbid bestehen.

4. Verfahren nach einem der Ansprüche 1 bis 3, wobei die Abstandshalter (12) und die Halteelemente (13) durch Verbindungen vom Bajonett-Typ an der Trägerplatte (11) befestigt wird.

## Claims

1. Method for heat treating a silicon wafer (8) in which timepiece components are etched, in which method the wafer (8) is thermally oxidized in an oxidation furnace, the wafer (8) being supported during the oxidation by a support member (11, 12, 13) comprising a support plate (11) and spacers (12) and retaining elements (13) carried by the support plate (11), the spacers (12) maintaining a spacing between the support plate (11) and the wafer (8), the retaining elements (13) preventing the wafer (8) from moving horizontally.

2. Method according to claim 1, wherein the support plate (11) is made of silicon, quartz or silicon carbide.

3. Method according to claim 1 or 2, wherein the spacers (12) and the retaining elements (13) are made of quartz or silicon carbide.

4. Method according to one of claims 1 to 3, wherein the spacers (12) and the retaining elements (13) are fixed to the support plate (11) by bayonet-type connections.
